# EUROPÄISCHE PATENTANMELDUNG

(11) **EP 4 712 110 A1**
(43) Veröffentlichungstag der Anmeldung: **18.03.2026**
(21) Anmeldenummer: 25191941.1
(22) Anmeldetag: 25.07.2025
(51) Int. Cl.: H01B 17/30, F04B 39/12, H05K 5/06

(54) **ELEKTRISCHE DURCHFÜHRUNG UND VERFAHREN ZU DEREN HERSTELLUNG**

(30) Priorität: 06.09.2024 DE 102024125574
(71) Anmelder: SCHOTT AG, 55122 Mainz (DE)
(72) Erfinder: HARTL, Helmut, 84028 Landshut (DE)
(74) Vertreter: Schott Corporate IP

(57) **Zusammenfassung**

Elektrische Durchführung (1) umfasst einen Grundkörper (10) mit einem Dichtungsbereich, zumindest einer Öffnung (12) und einen durch die Öffnung (12) hindurchgeführten elektrischen Leiter (30), wobei der Leiter (30) in der Öffnung (12) mit einem Fixiermaterial (20) gehalten ist und das Fixiermaterial (20) die Öffnung (12) abdichtet. Die Kanten, welche die Öffnung (12) umgeben, sind scharf ausgebildet und alle Kanten einer Außenkontur des Grundkörpers (10) sind mit einer Fase oder einer Verrundung (18) versehen, welche eine Größe bzw. einen Radius r im Bereich von 0,3 mm bis 2 mm auf-weist.

## Beschreibung

Die Erfindung betrifft eine elektrische Durchführung umfassend einen Grundkörper mit zumindest einer Öffnung und einen durch die Öffnung hindurchgeführten elektrischen Leiter, wobei der Leiter in der Öffnung mit einem Fixiermaterial gehalten ist und das Fixiermaterial die Öffnung abdichtet. Ein Weiterer Aspekt der Erfindung betrifft ein Verfahren zur Herstellung einer solchen elektrischen Durchführung.

### Stand der Technik

Gehäuse für elektrische oder elektronische Komponenten erfordern in der Regel eine Vielzahl von elektrischen Durchführungen, um elektrische Verbindungen von außen in das Innere des Gehäuses zu ermöglichen, in dem sich z. B. Teile eines elektrischen Kompressors (E-Kompressor) befinden. Die elektrischen Durchführungen müssen flüssigkeitsdicht oder sogar hermetisch dicht sein, um die Komponenten im Gehäuse vor der Umgebung zu schützen und/oder Gase oder Flüssigkeiten im Inneren des Gehäuses zu halten. Um solche flüssigkeitsdichten oder hermetischen Durchführungen für einen elektrischen Leiter zu erhalten, der in einer Öffnung des Gehäuses angeordnet ist, können Glas-Metall-Durchführungen verwendet werden. Ein Fixiermaterial, beispielsweise ein Glasmaterial, wird dabei verwendet, um die Öffnung abzudichten und den Leiter in der Öffnung zu halten. Das Fixiermaterial sorgt auch für eine elektrische Isolierung zwischen dem Leiter und dem Gehäuse.

Bei den bekannten Durchführungen bildet ein im Wesentlichen plattenförmiges Element einen Grundkörper aus, durch den die elektrischen Leiter hindurchgeführt sind. Dieser Grundkörper wiederum kann dann in eine Öffnung eines Gehäuses eines elektrischen oder elektronischen Geräts eingesetzt werden, wie beispielsweise einem E-Kompressor. Um eine Abdichtung zwischen dem Grundkörper und dem Gehäuse zu gewährleisten, müssen Dichtflächen am Grundkörper glatt und eben sein.

Aus WO2021070817A1 ist eine elektrische Durchführung bekannt, bei der ein Außenleiter bzw. ein Grundkörper rahmenförmige oder balkenförmige Verlängerungsabschnitte als Verstärkungsstruktur aufweist. Diese kann den gesamten Außenleiter umgeben oder nur an Längsseiten eines plattenförmigen Grundkörpers angeordnet sein.

Zur Herstellung der rahmenförmigen oder balkenförmigen Verlängerungsabschnitte wird ein zunächst plattenförmiger Grundkörper aus einem Bandmaterial ausgestanzt und anschließend mittels eines mehrstufigen Ziehprozesses umgeformt, beispielsweise unter Verwendung von Tiefziehen. Die bei dem Stanzen entstehenden Kanten des Grundkörpers sind scharf und weisen einen Radius von weniger als 0,3 mm auf. Werden die Grundkörper wie ein Schuttgut behandelt, so dass diese aneinander schlagen können, können die Dichtflächen durch diese scharfen Kanten beschädigt werden, so dass diese nicht mehr glatt und als Dichtfläche geeignet sind.

Eine Handhabung des Grundkörpers bzw. einer Vielzahl von Grundkörpern als Schüttgut wäre aber wünschenswert, um Produktionsprozesse bei der Fertigung der elektrischen Durchführung einfach und effizient gestalten zu können.

Eine Aufgabe der Erfindung ist das Bereitstellen einer elektrischen Durchführung, bei der der Grundkörper ohne Beschädigung von Dichtflächen als Schüttgut behandelt werden kann und somit die Herstellung der elektrischen Durchführung vereinfacht.

### Offenbarung der Erfindung

Es wird eine elektrische Durchführung vorgeschlagen, welche einen Grundkörper mit einem Dichtungsbereich, zumindest einer Öffnung und einen durch die Öffnung hindurchgeführten elektrischen Leiter umfasst, wobei der Leiter in der Öffnung mit einem Fixiermaterial gehalten ist und das Fixiermaterial die Öffnung abdichtet. Dabei ist vorgesehen, dass Kanten, welche die Öffnung umgeben, scharf ausgebildet sind und alle Kanten einer Außenkontur des Grundkörpers mit einer Fase oder einer Verrundung versehen sind, welche eine Größe bzw. einen Radius r im Bereich von 0,3 mm bis 2 mm aufweist, bevorzugt im Bereich von 0,5 mm bis 1,5 mm, besonders bevorzugt von 0,75 mm bis 1,0 mm.

Der Grundkörper ist bevorzugt plattenförmig mit einer im Wesentlichen rechteckigen Grundform ausgestaltet. Dabei ist die Längsseite und damit die Längskanten des Grundkörpers gerade ausgeführt. Die Querseite des Grundkörpers kann ebenfalls gerade ausgebildet sein, es sind aber auch gebogene Formen und Kombinationen aus geraden und gebogenen Abschnitten möglich. Beispielsweise kann die Querseite eine Bogenform aufweisen, deren Radius im Wesentlichen der halben Breite B/2 des Grundkörpers entspricht. Des Weiteren kann ein gerader Abschnitt in der Mitte mit gebogenen Übergängen zu den Längsseiten vorgesehen sein. Ein weiteres Beispiel ist ein gebogener Abschnitt in der Mitte der Querseite, der über zwei kurze gerade Abschnitte bzw. Fasen in die Längsseite übergeht.

Bevorzugt liegt ein Seitenverhältnis L/B der längsten Seite L zu der Breite B des Grundkörpers im Bereich von 1,5 bis 10, besonders bevorzugt im Bereich von 2 bis 5. Größere Seitenverhältnisse erlauben das Anordnen von mehr durchgeführten Leitern nebeneinander in derselben elektrischen Durchführung.

Der Grundkörper weist bevorzugt einen vertikalen Rand auf, wobei der Rand bzw. die Fläche des Rands einen Winkel von im Wesentlichen 90° zu der Oberseite und der Unterseite des Grundkörpers einschließt. Dabei sind mit "im Wesentlichen" Fertigungstoleranzen mit umfasst, insbesondere Abweichungen im Winkel von +/- 5°.

Die vorgesehene Fase oder Verrundung liegt zumindest an den Kanten der Außenkontur des Grundkörpers vor. Die Kanten der Außenkontur sind im Fall eines im Wesentlichen rechteckig ausgeführten Grundkörpers diejenigen Kanten, welche den Übergang zwischen der Oberseite bzw. der Unterseite zu dem vertikalen Rand bilden. Im Fall einer Verrundung ist die entsprechende Kante mit einem Radius versehen, der im Bereich von 0,3 mm bis 2 mm liegt, bevorzugt im Bereich von 0,5 mm bis 1,5 mm, besonders bevorzugt von 0,75 mm bis 1,0 mm. Im Fall einer Fase wird ein gestufter Übergang zwischen der Oberseite bzw. der Unterseite und dem vertikalen Rand geschaffen, wobei anstelle eines Winkels von ca. 90° der Übergang in zumindest zwei Stufen mit jeweils weniger als 90°, also z.B. jeweils 45° oder z.B. 30° und 60° erfolgt. Die Größe der Fase ist dabei der Abstand zwischen diesen beiden Stufen, wobei die Größe im Bereich von 0,3 mm bis 2 mm liegt, bevorzugt im Bereich von 0,5 mm bis 1,5 mm, besonders bevorzugt von 0,75 mm bis 1,0 mm.

Der Grundkörper der Durchführung umfasst bevorzugt mehrere Öffnungen, durch die jeweils ein elektrischer Leiter hindurchgeführt ist und mit dem Fixiermaterial gehalten ist. Das Fixiermaterial dichtet dabei gegen die Wandung der Öffnung und den Leiter. Die Durchführung umfasst bevorzugt zwischen zwei und fünf durchgeführte Leiter, beispielsweise sind genau drei elektrische Leiter durchgeführt. Alternativ dazu kann die Durchführung aber auch genau einen durchgeführten elektrischen Leiter umfassen.

Der Grundkörper kann weitere Öffnungen umfassen, welche als Befestigungsöffnungen dienen. Durch die Befestigungsöffnungen kann die Durchführung beispielsweise über Schrauben an einem Gehäuseteil befestigt werden.

Zumindest die Öffnungen, durch die ein elektrischer Leiter hindurchgeführt ist und mit dem Fixiermaterial gehalten ist, weisen eine scharfe Kante am Übergang einer Innenwandung der Öffnung zu den Oberflächen der Oberseite und der Unterseite des Grundkörpers auf. Eine Kante wird insbesondere dann als scharf angesehen, wenn diese nicht mit einer Verrundung oder mit einer Fase versehen ist bzw. eine Verrundung oder Fase aufweist, welche einen Radius bzw. eine Größe von weniger als 0,3 mm, besonders bevorzugt von weniger als 0,2 mm und am meisten bevorzugt von weniger als 0,1 mm aufweist. Da ein abrupter, perfekt scharfer Übergang in der Praxis nicht realisierbar ist, beträgt der Radius der scharfen Kante in der Regel mehr als 50 nm. Die scharfen Kanten der Öffnung lassen sich beispielsweise durch Stanzen erzeugen.

Scharfe Kanten am Übergang zu den Innenwänden der Öffnung weisen den Vorteil auf, dass das Fixiermaterial und die Innenwandung an einer geraden vertikalen Wand aneinanderstoßen. Bei einer Verrundung oder einer Fase würde sich die Wand im Bereich des oberen Abschlusses des Fixiermaterials von dem Fixiermaterial weg krümmen und damit eine Verbindung zwischen diesen schwächen. Bei mechanischer Belastung könnten in diesem Bereich Teile des Fixiermaterials abplatzen und die Durchführung insgesamt schwächen oder undicht werden lassen.

Des Weiteren kann entlang der Außenkante bzw. Außenkontur des Grundkörpers eine oder mehrere Kerben angeordnet sein. Durch diese Kerben kann bei einem ansonsten entlang einer oder mehrerer Punkte oder entlang einer oder mehrerer Ebenen symmetrisch ausgestalteter Grundkörper eindeutig orientiert werden. Insbesondere kann damit die Oberseite des Grundkörpers von dessen Unterseite unterscheidbar gemacht werden. Bei den Stanzprozessen ergibt sich üblicherweise ein Unterscheid zwischen der Oberseite und der Unterseite eines Bauteils über eine leichte Biegung oder Wölbung, wobei die Oberseite beispielsweise leicht konvex und die Unterseite leicht konkav gewölbt sein kann. Für den Einbau der Durchführung in ein Gehäuse kann dabei jeweils eine der Orientierungen vorteilhafter als die jeweils andere sein.

Auf der Oberseite und/oder auf der Unterseite des Grundkörpers der Durchführung ist ein Dichtungsbereich vorgesehen, der im Wesentlichen glatt und eben ist und insbesondere frei von Kerben und Kratzern ist. Über diesen Dichtungsbereich kann ein Dichtelement, wie beispielsweise ein O-Ring gegen den Dichtungsbereich des Grundkörpers und einem Dichtbereich an dem Gehäuse abdichten. Des Weiteren ist der Dichtungsbereich des Grundkörpers bevorzugt eben ausgestaltet, wobei der Dichtungsbereich bevorzugt eine Abweichung der Ebenheit ≤ 0,1 mm gemäß DIN EN ISO 1101, Stand 09/2017, insbesondere im Bereich 0,005 mm bis 0,02 mm pro 10 mm Länge aufweist.

Bevorzugt ist der Grundkörper mit einer Oberflächenbeschichtung versehen. Mit der Beschichtung kann die Widerstandsfähigkeit des Materials des Grundkörpers insbesondere gegen korrosive Umwelteinflüsse gesteigert werden.

Bei der Oberflächenbeschichtung handelt es sich bevorzugt um eine Nickelschicht, welche galvanisch oder chemisch auf der Oberfläche des Metallmaterials des Grundkörpers abgeschieden werden kann. Im Fall einer galvanischen Beschichtung wird die Beschichtung bevorzugt durch Trommelbeschichten erhalten. Die Beschichtung ist bevorzugt auf der gesamten Oberfläche des Grundkörpers angeordnet und ist bevorzugt frei von Lücken oder Fehlstellen.

Bevorzugt ist der Grundkörper aus Metall gefertigt, wobei das Metall bevorzugt ausgewählt ist aus der Gruppe umfassend Stahl, insbesondere unlegierten Stahl wie einem Stahl mit der Materialnummer 1.0338 oder Edelstahl, NiFe, Kovar, Titan und Kupfer.

Metallteile, insbesondere umgeformte Metallteile, weisen eine faserähnliche Struktur auf, welche als Faserverlauf oder metallurgische Fließlinien bezeichnet wird. Der Faserverlauf kann beispielsweise an einem Schnitt durch das Metallteil mit einem nasschemischen Ätzprozess sichtbar gemacht werden. Der Faserverlauf und dabei insbesondere dessen Richtung, wird durch Umformprozesse wie Tiefziehen beeinflusst.

Da das Metallmaterial parallel zu dem Faserverlauf seine größte mechanische Stabilität aufweist ist vorgesehen, die längste Seite des Grundkörpers, welche entsprechend der größten Gefahr eines Verzugs oder eines Verbiegens ausgesetzt ist, parallel zu dem Faserverlauf auszurichten. Dadurch wird ohne zusätzlichen Materialeinsatz die Biegesteifigkeit entlang der längsten Richtung des Grundkörpers verbessert.

Bevorzugt ist der Grundkörper aus einem Drahtprofil gefertigt, welches durch Walzen eines Drahts erhalten werden kann. Bei einem Drahtmaterial ist der Faserverlauf aufgrund des Drahtziehprozesses entlang der Richtung des Drahtes ausgerichtet. Durch Walzen des Drahts kann die Querschnittsform des Drahtmaterials angepasst werden, ohne dass die grundsätzliche Ausrichtung des Faserverlaufs verändert wird. Bevorzugt wird der Grundkörper aus einem Drahtprofil erhalten, dessen Querschnitt eine Höhe aufweist, die der Dicke des Grundkörpers entspricht, und einer Breite aufweist, die der Breite des Grundkörpers entspricht. Durch Abschneiden eines Stücks mit einer Länge, die der Länge des Grundkörpers entspricht, wird der Grundkörper mit Länge L, Breite B und Dicke D erhalten. Da die lange Seite entlang der Drahtziehrichtung des Drahtprofils ausgerichtet ist, ist auf diese Weise der Faserverlauf parallel zur langen Seite des Grundkörpers.

Da der Grundkörper an seiner kürzeren Seite mit der Breite B aus dem Drahtprofil abgeschnitten wird, ergibt sich gegenüber einem Herausschneiden aus einer Platte oder einem Abschneiden an der langen Längsseite mit der Länge L eine deutlich kürzere Schneid- bzw. Stanzlänge. Das ermöglicht ein Herstellen des Grundkörpers mit einer kleineren Stanzmaschine und reduziertem Werkzeugaufwand.

Der elektrische Leiter besteht aus einem elektrisch leitenden Leitermaterial, wie z. B. einem Metall. Vorzugsweise besteht der mindestens eine elektrische Leiter aus einem Leitermaterial, das aus der Gruppe ausgewählt wird, die Stahl, insbesondere Edelstahl, eine Nickel-Eisen-Legierung und Kupfer umfasst. Darüber hinaus kann der Leiter einen Kern aus einem hochleitfähigen Material, wie z. B. Kupfer, und ein anderes Material als Außenhülle aufweisen.

Das Fixiermaterial ist bevorzugt ein Glasmaterial oder ein Glaskeramikmaterial. Über das Fixiermaterial wird der elektrische Leiter in der Öffnung des Grundkörpers gehalten und elektrisch gegenüber dem Grundkörper isoliert. Des Weiteren dichtet das Fixiermaterial gegen die Innenwand der Öffnung und den elektrischen Leiter die Öffnung ab.

Vorzugsweise bilden der Grundkörper, der mindestens eine Leiter und das Fixiermaterial eine Glas-Metall-Durchführung in Form einer Druckeinglasung. Dementsprechend wird ein erster Wärmeausdehnungskoeffizient des Grundkörpers vorzugsweise größer als ein zweite Wärmeausdehnungskoeffizient des Fixiermaterials gewählt. Um eine Druckeinglasung zu erhalten, sollte der Unterschied zwischen dem ersten und dem zweiten Wärmeausdehnungskoeffizienten in dem Temperaturbereich von 300 K bis 600 K vorzugsweise mindestens 2 ppm/K und weiter bevorzugt mindestens 5 ppm/K betragen. Ein dritter Wärmeausdehnungskoeffizient des Leitermaterials des elektrischen Leiters wird vorzugsweise so gewählt, dass dieser etwa gleich ist oder kleiner ist als der zweite Wärmeausdehnungskoeffizient des Fixiermaterials. Zwei Wärmeausdehnungskoeffizienten werden als ungefähr gleich angesehen, wenn die Differenz weniger als 2 ppm/K beträgt.

In Verbindung mit der Ausführung der Durchführung als Druckglasdurchführung, bei dem das Fixiermaterial durch den Grundkörper unter einem kompressiven Druck steht, wirkt sich ein Ausrichten des Faserverlaufs bzw. der metallurgischen Fließlinien parallel zur Längsseite mit der Länge L vorteilhaft aus, da so eine besonders hohe Festigkeit bei geringem Materialverbrauch und geringer Größe erzielt wird.

Alternativ zu einer Druckeinglasung können das Material des Grundkörpers, das Fixiermaterial und das Leitermaterial so gewählt werden, dass ihre jeweiligen Wärmeausdehnungskoeffizienten ungefähr gleich sind, wobei eine Differenz von weniger als 2 ppm/K als ungefähr gleich angesehen wird. In dieser Variante bilden der Grundkörper, der mindestens eine Leiter und das Fixiermaterial eine angepasste Glas-Metall-Durchführung aus.

Die gebildete Glas-Metall-Durchführung ist bevorzugt hermetisch dicht, wobei eine Durchführung mit einer He Leckrate von weniger als 1•10⁻⁷ mbar I/s, bevorzugt weniger 1•10⁻⁸ mbar I/s bei einer Druckdifferenz von 1 bar als hermetisch dicht angesehen wird.

Bevorzugt weist der Grundkörper zumindest an den Rändern der Längsseite eine Verstärkungsstruktur auf, wobei die Verstärkungsstruktur bevorzugt als erhöhter Randbereich ausgeführt ist, der gegenüber einer Grundebene des Grundkörpers vertikal versetzt ist.

Bevorzugt ist der erhöhte Randbereich vertikal gegenüber einer Grundebene des Grundkörpers versetzt, wobei eine Stärke S1 des Randbereichs einer Dicke D des Grundkörpers entspricht. Hierzu kann der erhöhte Randbereich mittels Schubumformen umgeformt sein. Das führt dazu, dass eine Verbindungsstelle bzw. ein Anbindungsbereich zwischen dem erhöhten Randbereich und dem Rest des Grundkörpers eine geringere Höhe aufweist als die Dicke des Grundkörpers.

Der Grundkörper besteht bevorzugt aus einem Metallmaterial, wobei der erhöhte Randbereich mittels Schubumformen aus einem flachen Rohling erhalten wurde. Die Grundebene ist dabei insbesondere eine Ebene, welche durch die Längsrichtung und Querrichtung aufgespannt wird bzw. senkrecht zu einer Achse der Öffnungen im Grundkörper orientiert ist und an den Randbereich angrenzt. Entsprechend wird durch das vertikale Versetzen Material des Grundkörpers senkrecht zu der Grundebene verschoben.

Durch das vertikale Verschieben bzw. das Schubumformen zum Erhalten des erhöhten Randbereichs wird ein Faserverlauf des Metallmaterials des Grundkörpers an der Verbindungsstelle verdichtet und oberhalb bzw. unterhalb der Verbindungsstelle abgetrennt.

Im Fall eines im Wesentlichen rechteckigen Grundkörpers ist der erhöhte Randbereich bevorzugt zumindest an den Kanten der Längsseiten angeordnet, wobei der Randbereich dabei über die gesamte Länge der Längsseite angeordnet sein kann. Der Randbereich kann aber auch unterbrochen sein und/oder nur an einem Teil der Längsseiten angeordnet sein. Des Weiteren kann der erhöhte Randbereich auch an den Querseiten angeordnet sein, wobei wiederum der erhöhte Rand über die gesamte Länge der Querseite angeordnet sein kann, aber auch unterbrochen sein kann und/oder nur an einem Teil der Querseite angeordnet sein kann. Bevorzugt ist der erhöhte Randbereich wie ein Verstärkungsring vollständig um die Außenkontur des Grundkörpers herum angeordnet. Alternativ zu einer rechteckigen Grundform kann der Grundkörper beispielsweise kreisrund geformt sein, wobei dann der erhöhte Randbereich bevorzugt ringförmig vollständig um die Außenkontur des Grundkörpers umläuft.

Durch das vertikale Verschieben des Materials zum Erhalten des erhöhten Randbereichs entsteht an der Unterseite des Grundkörpers komplementär dazu eine Stufe. Diese Stufe kann als ein mechanischer Anschlag bzw. als eine Zentrierhilfe dienen, wenn die Durchführung mit dem Grundkörper in eine Öffnung eines Gehäuses eingesetzt wird. Die relative Position der elektrischen Durchführung zu dem Gehäuse kann dadurch genauer festgelegt werden und eine Montage der elektrischen Durchführung wird erleichtert.

An der Oberseite des Grundkörpers bildet der erhöhte Randbereich eine Wand aus. Diese kann als ein mechanischer Anschlag bzw. als eine Zentrierhilfe für ein zusätzliches Isolationselement dienen, welches auf die elektrische Durchführung aufgesetzt wird. Ein solches zusätzliches Isolationselement, welches beispielsweise aus einem elastischen Material oder einem thermoplastischen oder duroplastischen Kunststoff gefertigt ist, kann verwendet werden, um eine Isolationsstrecke oder Kriechstrecke zwischen einem der durchgeführten elektrischen Leiter und dem Grundkörper der Durchführung zu verlängern.

Bevorzugt ist um die mindestens eine Öffnung herum ein erhöhter oder vertiefter Verstärkungsbereich ausgebildet, wobei der erhöhte oder vertiefte Verstärkungsbereich vertikal gegenüber einer Grundebene des Grundkörpers versetzt ist und wobei eine Stärke des erhöhten oder vertieften Verstärkungsbereichs einer Dicke des Grundkörpers entspricht. Der Verstärkungsbereich kann wie der Randbereich mittels Schubumformen erhalten werden.

Weist der Grundkörper mehr als eine Öffnung auf, kann für jede der Öffnungen jeweils ein eigener erhöhter oder vertiefter Verstärkungsbereich vorgesehen sein. Alternativ dazu kann auch ein einziger erhöhter oder vertiefter Verstärkungsbereich vorgesehen sein, der alle Öffnungen zur Durchführung eines elektrischen Leiters umfasst. Die Befestigungsöffnungen, sofern vorhanden, können dabei außerhalb des erhöhten oder vertieften Verstärkungsbereichs liegen.

Da der Randbereich und ggf. der Verstärkungsbereich nur durch vertikales Verschieben des Materials des Grundkörpers gegenüber einer Grundebene des Grundkörpers erhalten werden, ist zum Ausbilden dieser Bereiche kein zusätzliches Material erforderlich. Die Materialmenge entspricht genau dem eines flachen Grundkörpers mit denselben Abmessungen in Länge und Breite bei einer rechteckigen Grundform bzw. Durchmesser im Fall einer runden Grundform. Dennoch wird die mechanische Stabilität des Grundkörpers gesteigert und insbesondere eine Resistenz gegen ein Verbiegen des Grundkörpers erhöht.

Die durch das vertikale Verschieben entstehenden Kanten sind zumindest dann verrundet oder mit einer Fase versehen, wenn diese Kanten Teil der Außenkontur sind.

Bevorzugt sind alle Kanten des Grundkörpers, welche nicht eine Öffnung um Grundkörper umgeben, mit einer Verrundung oder einer Fase versehen.

Insbesondere bei Herstellung mittels Schubumformen ist der erhöhte Randbereich und/oder der erhöhte oder vertiefte Verstärkungsbereich um weniger als die Dicke D des Grundkörpers gegenüber einer Grundebene des Grundkörpers versetzt. Die Grundebene ist dabei die ursprüngliche, vor dem Anwenden des Umformens vorhandene Ebene an der Oberfläche des plattenförmigen Grundkörpers bzw. eines Rohlings des Grundkörpers und entspricht nach dem Schubumformen der Ebene, die an den erhöhten Randbereich angrenzt.

Bevorzugt ist der erhöhte Randbereich und/oder der erhöhte oder vertiefte Verstärkungsbereich in Bezug auf die Dicke D des Grundkörpers im Bereich von 20 % bis 80% in vertikaler Richtung versetzt.

Durch Schubumformen kann dann der Grundkörper aus einem flachen Rohling erhalten werden, wobei der Rohling die Dicke D aufweist und bereits die Länge und Breite bzw. den Durchmesser des fertigen Grundkörpers aufweist. Eine Oberfläche des Rohlings kann dann als Grundebene angesehen werden. Der Randbereich und/oder der Verstärkungsbereich können dann durch vertikales Verschieben gegenüber der Grundebene des Rohlings erhalten werden.

Da der erhöhte Randbereich und/oder der Verstärkungsbereich durch vertikales Verschieben von Material des Rohlings erhalten werden, weist der Grundkörperüber alle Bereiche, also den Randbereich, den Verstärkungsbereich und einen unbearbeiteten Grundbereich, dieselbe konstante Dicke D auf. Es wird kein zusätzliches Material benötigt, um den Randbereich und/oder den Verstärkungsbereich auszubilden.

Die hierin beschriebenen elektrischen Durchführungen sind insbesondere für Kompressoren geeignet. Dabei sind die elektrischen Durchführungen besonders für Anwendungen in elektrisch angetriebenen Kompressoren, sogenannten E-Kompressoren, geeignet, welche zur Kühlung des Innenraums elektrisch angetriebener Fahrzeuge eingesetzt werden.

Entsprechend ist die elektrische Durchführung bevorzugt als ein Anschlussterminal für einen E-Kompressor ausgebildet.

Ein weiterer Aspekt der Erfindung ist das Bereitstellen eines Verfahrens zur Herstellung der hierin beschriebenen elektrischen Durchführungen. Entsprechend gelten im Rahmen der elektrischen Durchführung beschriebene Merkmale für die Verfahren und umgekehrt gelten im Rahmen der Verfahren beschriebene Merkmale für die elektrischen Durchführungen.

Ein Verfahren zur Herstellung einer der hierin beschriebenen elektrischen Durchführungen umfasst das Formen eines Grundkörpers mit zumindest einer Öffnung aus einem Rohling, wobei Kanten, welche die Öffnung umgeben, scharf ausgebildet werden und zumindest die Kanten einer Außenkontur des Grundkörpers mit einer Fase oder einer Verrundung versehen werden, welche einen Radius r im Bereich von 0,3 mm bis 2 mm aufweist. Nachfolgend erfolgt ein Einsetzen eines Fixiermaterialrohlings und eines Leiters in zumindest eine der Öffnungen, und das Ausführen einer Temperaturbehandlung zum Ausbilden des Fixiermaterials aus dem Fixiermaterialrohling.

Bevorzugt werden das Erzeugen der Öffnungen und das Einbringen der Fasen und/oder Rundungen an den Kanten in einem gemeinsamen Arbeitsschritt ausgeführt. Das kann beispielsweise ein kombiniertes Stanzen und Prägen sein.

In einer Variante des Verfahrens wird der Grundkörper aus einem Drahtmaterial geformt. Dabei wird das Drahtmaterial durch Walzen in eine Querschnittsform gebracht, bei der die Abmessung einer langen Seite der Breite B einer Querseite des Grundkörpers und die Abmessung einer kurzen Seite der Dicke D des Grundkörpers entspricht. Das Formen des Grundkörpers umfasst ein Abtrennen eines Rohlings aus dem Drahtmaterial, wobei eine Länge einer Längsseite des Rohlings der Länge L der Längsseite des Grundkörpers entspricht, wobei das Drahtmaterial bereits vor dem Abtrennen des Rohlings an seinen Kanten mit einer Verrundung mit Radius r versehen ist. Dabei bildet diese Verrundung nach dem Abtrennen eine Verrundung entlang der Kanten an den Längsseiten des Grundkörpers. Das Abtrennen des Rohlings kann in einem Gemeinsam mit einem Stanzen der Öffnungen in einem einzigen Arbeitsschritt erfolgen.

Ein erhöhter Randbereich zur Verstärkung der Biegesteifigkeit des Grundkörpers wird bevorzugt mittels Schubumformen hergestellt.

Bevorzugt wird der Grundkörper, nachdem dieser seine endgültige Form erhalten hat, also vor dem Einsetzen des Fixiermaterialrohlings und des Leiters und dem Ausführen der Temperaturbehandlung, unter Verwendung eines Trommelbeschichtungsverfahrens galvanisch mit Nickel beschichtet.

Bei dem Trommelbeschichten stellt eine leitfähige Trommel einen elektrischen Kontakt zu den zu beschichtenden Grundkörpern her. Die Grundkörper befinden sich dabei zusammen mit dem Elektrolyten in der Trommel, welche sich dreht, damit nach und nach alle Oberflächen gleichmäßig beschichtet werden.

Hierbei wird vorteilhaft ausgenutzt, dass die Grundkörper jeweils ausschließlich abgerundete bzw. mit Fasen versehene Kanten an den Außenkonturen aufweisen. Die Grundkörper haben dabei in der Trommel jeweils elektrisch Kontakt zur Trommel bzw. zu benachbarten Grundkörpern, so dass diese galvanisch beschichtet werden können. Bei Drehung der Trommel bewegen sich die Grundkörper relativ zueinander und stoßen aneinander, wobei jeweils andere Teile des Grundkörpers dem Elektrolyten ausgesetzt sind. Durch die abgerundeten bzw. mit Fasen versehenen Kanten bleibt aber die Oberfläche der Grundkörper glatt und frei von Kerben und/oder Kratzern. Dichtflächen bleiben somit erhalten.

Im Gegensatz zu stromlosen Verfahren zum Aufbringen der Nickelschicht enthält die elektrolytisch abgeschiedene Nickelschicht kein Phosphor bzw. ist bis auf Verunreinigungen frei von Phosphor. Im Vergleich zu galvanischen Verfahren, bei denen die zu beschichtenden Bauteile einzeln mit einer Elektrode elektrisch kontaktiert werden, ist die Beschichtung vollständig geschlossen und weist keine Fehlstelle an dem Ort der elektrischen Kontaktierung auf.

Die Erfindung soll nachfolgend anhand der Figuren und ohne Beschränkung hierauf eingehender beschrieben werden. Gleiche Bezugszeichen bezeichnen dabei gleiche oder ähnliche Elemente.

Es zeigen:
Fig. 1: eine perspektivische Ansicht eines Grundkörpers mit abgerundeten Kanten der Außenkontur,
Fig. 2: eine Schnittansicht eines Grundkörpers von der Seite,
Fig. 3 eine elektrische Durchführung mit dem Grundkörper in einer Schnittansicht von der Seite,
Fig. 4 ein Grundkörper mit Verstärkungsstruktur in einer Schnittansicht von der Seite,
Fig. 5 ein Grundkörper mit Verstärkungsstruktur und Verstärkungsbereichen in einer perspektivischen Darstellung,
Fig. 6 ein gewalztes Drahtmaterial als Ausgangsprodukt, und
Fig. 7 ein aus dem Drahtmaterial erhaltener Grundkörper in einer perspektivischen Darstellung.

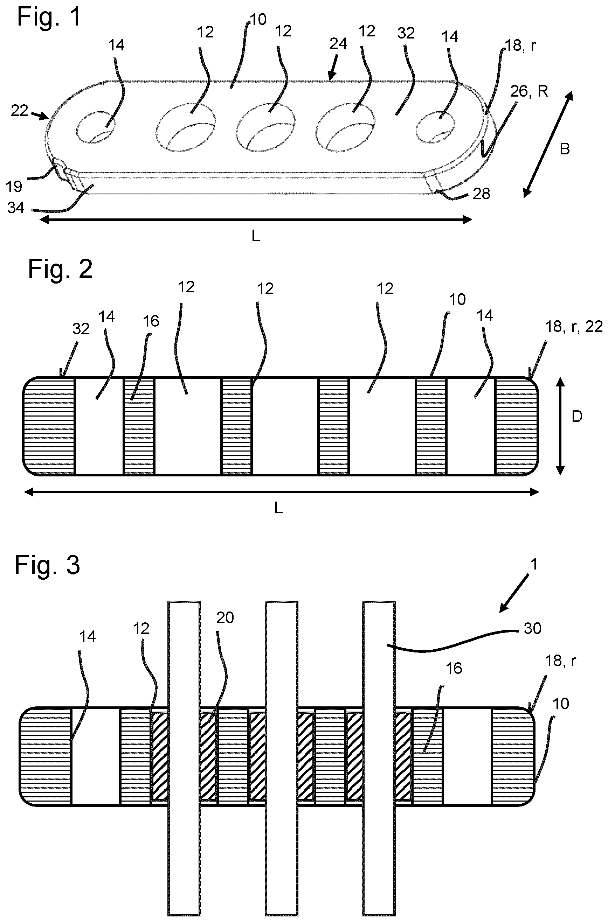

Figur 1 zeigt schematisch einen Grundkörper 10 für eine elektrische Durchführung 1, vergleiche Figur 3, in einer perspektivischen Darstellung. Die Form des Grundkörpers 10 ist in dem skizzierten Beispiel im Wesentlichen rechteckig, wobei die langen Seiten 24 mit der Länge L gerade ausgeführt sind und die kurzen Seiten 26 bogenförmig mit einem Radius R ausgeführt sind. Am Übergang zwischen den kurzen Seiten 26 und den Langen Seiten ist eine Fase 28 ausgebildet. Der Grundkörper 10 weist eine Breite B auf.

Für das Durchführen von elektrischen Leitern 30, vergleiche Figur 3, sind in dem in Figur 1 dargestellten Beispiel drei Öffnungen 12 vorgesehen. Zusätzlich weist der in Figur 1 skizzierte Grundkörper 10 zwei Befestigungsöffnungen 14 auf, über die dieser beispielsweise mit einem Gehäuse verschraubt werden kann.

Der Grundkörper 10 weist einen vertikalen Rand 34 auf, wobei der vertikale Rand 34 bzw. die Fläche des vertikalen Rands 34 einen Winkel von im Wesentlichen 90° zu der Oberseite 32 und der Unterseite des Grundkörpers 10 einschließt.

Wie der Figur 1 entnommen werden kann, ist entlang einer Außenkontur, welche den Übergang zwischen der Oberseite 32 bzw. der Unterseite zu dem vertikalen Rand 34 bildet, eine Verrundung 18 mit Radius r angeordnet. Die Konturen, welche einen Übergang zwischen der Oberseite 32 bzw. der Unterseite des Grundkörpers 10 zu Innenwandungen der Öffnungen 12 und der Befestigungsöffnungen 14 bilden, sind hingegen scharf ausgebildet.

Zum Aufheben einer Symmetrie ist an einer Stelle der Außenkontur des Grundkörpers 10 eine Kerbe 19 angeordnet. Durch das Aufheben der Symmetrie lassen sich die Oberseite 32 und die Unterseite des Grundkörpers 10 besser unterscheiden.

Figur 2 zeigt eine Schnittansicht des in Figur 1 gezeigten Grundkörpers 10 von der Seite. In dieser Darstellung ist gut zu erkennen, dass die Außenkontur mit der Verrundung 18 mit Radius r versehen ist, während Übergänge von der Überseite 32 bzw. der Unterseite des Grundkörpers 10 zu den Innenwandungen der Öffnungen 12 und den Befestigungsöffnungen 14 scharf ausgebildet sind. Zur Erhöhung der Biegesteifigkeit sind in dem skizzierten Beispiel metallurgische Fließlinien bzw. eine Faserstruktur 16 des Metallmaterials des Grundkörpers 10 parallel zur Längsseite 24 der Länge L ausgerichtet.

Figur 3 zeigt eine elektrische Durchführung 1 mit dem mit Bezug zu den Figuren 1 und 2 beschriebenen Grundkörper 10. Durch jede der Öffnungen 12 ist ein Leiter 30 hindurchgeführt, der jeweils mit einem Fixiermaterial 30 in der jeweiligen Öffnung 12 gehalten ist. Das Fixiermaterial 30 dichtet dabei die jeweils gegen den Leiter 30 und die Innenwandung der Öffnung 12 ab.

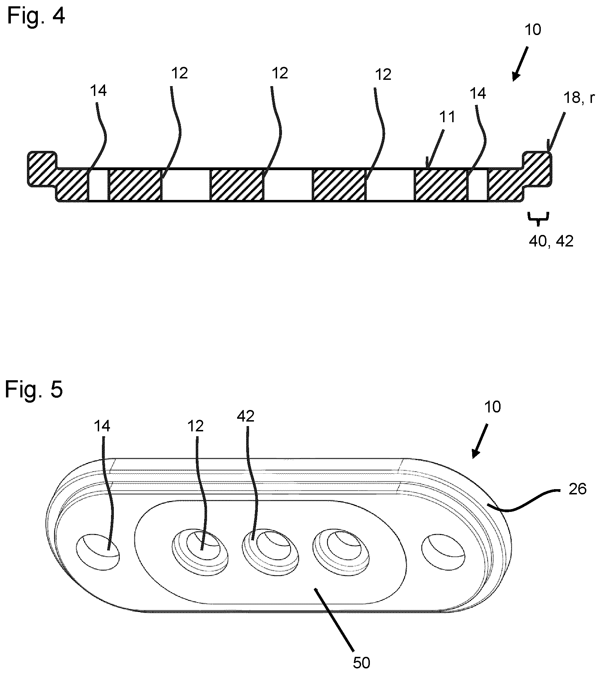

In den Figuren 4 und 5 ist ein zweites Beispiel für einen Grundkörper 10 dargestellt. Dieser weist wie der mit Bezug zu den Figuren 1 und 2 beschriebene Grundkörper 10 drei Öffnungen 12 für das Durchführen von Leitern 30 und zwei Befestigungsöffnungen 14 auf. Die Außenkontur ist wieder mit einer Verrundung 18 mit Radius r versehen. Die Konturen an den Übergängen zu den Innenwandungen der Öffnungen 12 und Befestigungsöffnungen 14 sind hingegen scharf ausgebildet.

Im Gegensatz zu dem Beispiel der Figuren 1 und 2 ist der Grundkörper 10 nicht flach ausgebildet, sondern weist als eine Verstärkungsstruktur 40 in Form eines erhöhten Randbereichs 42 auf. Dieser erhöhte Randbereich 42 ist mittels Schubumformen gegeneiner Grundebene 11 des Grundkörpers 10 vertikal verschoben. Am Übergang von der Grundebene 11 zum erhöhten Randbereich 42 bildet sich eine Stufe aus, welche den Grundkörper 10 gegen ein Verbiegen versteift.

In der Figur 4 ist der Grundkörper 10 mit dem erhöhten Randbereich 42 in einer Schnittdarstellung von der Seite gezeigt. Figur 5 zeigt den Grundkörper 10 mit dem erhöhten Randbereich in einer perspektivischen Darstellung von unten. In der Darstellung der Figur 5 ist an der Unterseite ein Dichtungsbereich 50 um die Öffnungen 12 herum zu erkennen.

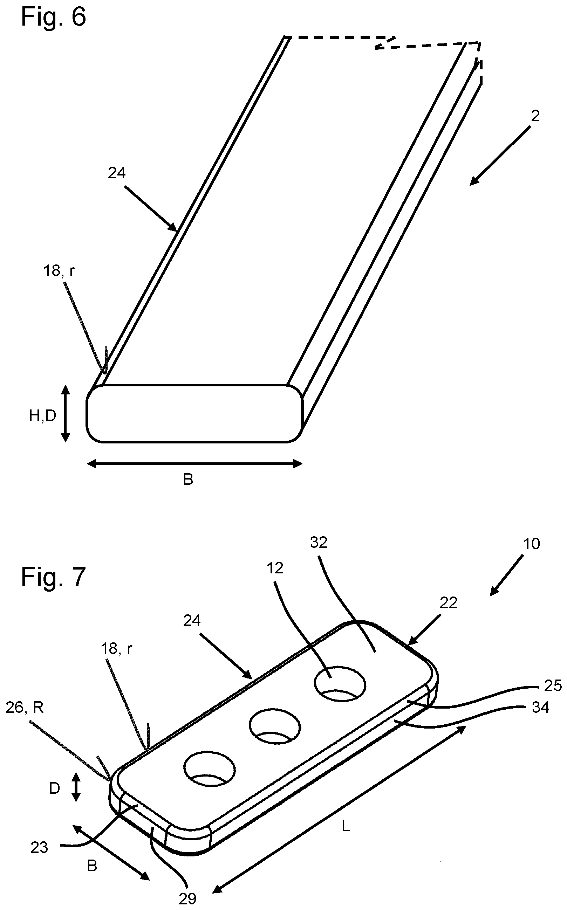

Figur 6 zeigt schematisch ein gewalztes Drahtmaterial 2. Das Drahtmaterial 2 weist eine Querschnittsform auf, welche eine Länge aufweist, die der Breite B einer Querseite 22 des herzustellenden Grundkörpers 10 entspricht, vergleiche Figur 7. Eine Höhe H der Querschnittsform des Drahtmaterials 2 entspricht der Dicke D des herzustellenden Grundkörpers 10.

Das gewalzte Drahtmaterial 2 wird beispielsweise durch Walzen eines runden, gezogenen Drahts erhalten. Durch das Walzen wird aus einem ursprünglichen kreisförmigen Querschnitt die in Figur 6 dargestellte im Querschnittsform in Form eines Rechtecks mit abgerundeten Ecken erhalten. Die abgerundeten Ecken stellen dabei einer Verrundung 18 der Längskanten 24 des gewalzten Drahtmaterials 2 mit einem Radius r dar.

Figur 7 zeigt einen Grundkörper 10 mit in diesem Beispiel drei Öffnungen 12. Der Grundkörper 10 weist eine im Wesentlichen rechteckige Form mit einer Längsseite 24 der Länge L, einer Querseite 22 der Breite B und einer Dicke D auf.

Der Grundkörper 10 weist einen vertikalen Rand 34 auf, wobei der vertikale Rand 34 bzw. die Fläche des vertikalen Rands 34 einen Winkel von im Wesentlichen 90° zu der Oberseite 32 bzw. der Unterseite des Grundkörpers 10 einschließt. An den Übergängen von der Oberseite 32 bzw. der Unterseite des Grundkörpers 10 zu dem vertikalen Rand 34 weist der Grundkörper 10 Kanten 23, 25 auf.

Die Längsseiten 24 des Grundkörpers 10 sind gerade ausgeführt, die Querseiten 22 sind in dem Beispiel der Figur 2 aus jeweils zwei gebogenen Abschnitten 26 mit einem Radius R und einem geraden Abschnitt 29 zusammengesetzt, wobei die beiden gebogenen Abschnitte 26 jeweils an die Längsseite 24 angrenzend angeordnet sind.

Der Grundkörper 10 wurde aus dem in Figur 6 gezeigtem Drahtmaterial 2 erhalten durch Abschneiden eines Rohlings der Länge L, Einbringen der Öffnungen 12 und Verrunden von Querkanten 23. Längskanten 25 sind dabei bereits vor dem Abschneiden verrundet, da bereits die Längsseite 24 des Drahtmaterials 1 entsprechende Verrundungen 18 aufweist. In dem in Figur 7 dargestellten Ausführungsbeispiel wurde für das Verrunden der Querkanten 23 derselbe Radius r gewählt wie für das Verrunden der Längskanten 25. Es ist aber selbstverständlich möglich, für die Querkanten 23 einen abweichenden Radius r' zu wählen oder anstelle einer Verrundung 18 eine Fase vorzusehen.

Durch das Versehen aller Kanten 23, 25 der Außenkontur des Grundkörpers 10 mit Verrundungen 18 weist der Grundkörper 10 keinerlei scharfe Kanten an seiner Außenkontur auf, welche bei Behandlung einer Vielzahl von Grundkörpern 10 als Schüttgut Oberflächen des Grundkörpers 10 beschädigen könnten. Somit bleiben Oberflächen wie die Oberseite 32 des Grundkörpers 10, die beispielsweise als Dichtbereich 50 dienen können, frei von Beschädigungen wie Kratzer oder Kerben. Dichtflächen des Grundkörpers 10 bleiben glatt und fehlerfrei.

Hingegen bleiben Kanten an den Übergängen der Wandungen der Öffnungen 12 zu der Oberfläche 32 frei von Verrundungen oder Fasen und somit scharfkantig. Dies verbessert das Anglasen des Fixiermaterials 20, vergleiche Figur 3, an die Wandung der Öffnung 12.

Obwohl die vorliegende Erfindung anhand bevorzugter Ausführungsbeispiele beschrieben wurde, ist sie nicht darauf beschränkt, sondern auf vielfältige Weise modifizierbar.

### Bezugszeichenliste

- 1: elektrische Durchführung
- 2: Drahtmaterial
- 10: Grundkörper
- 11: Grundebene
- 12: Öffnung
- 14: Befestigungsöffnung
- 16: metallurgische Fließlinien / Faserverlauf
- 18: Verrundung
- 19: Kerbe
- 20: Fixiermaterial

- 22: Querseite
- 23: Querkante
- 24: Längsseite
- 25: Längskante
- 26: gebogener Abschnitt
- 28: Fase
- 29: gerader Abschnitt
- 30: Leiter
- 32: Oberseite
- 34: vertikaler Rand

- 40: Verstärkungsstruktur
- 42: erhöhter Randbereich

- 50: Dichtungsbereich
- r: Radius Verrundung
- R: Radius Ecke/Kante
- D: Dicke Grundkörper
- B: Breite Grundkörper
- L: Länge Grundkörper

## Patentansprüche

1. Elektrische Durchführung (1) umfassend einen Grundkörper (10) mit einem Dichtungsbereich (50), zumindest einer Öffnung (12) und einen durch die Öffnung (12) hindurchgeführten elektrischen Leiter (30), wobei der Leiter (30) in der Öffnung (12) mit einem Fixiermaterial (20) gehalten ist und das Fixiermaterial (20) die Öffnung (12) abdichtet, **dadurch gekennzeichnet, dass** Kanten, welche die Öffnung (12) umgeben, scharf ausgebildet sind und alle Kanten einer Außenkontur des Grundkörpers (10) mit einer Fase oder einer Verrundung (18) versehen sind, welche eine Größe bzw. einen Radius r im Bereich von 0,3 mm bis 2 mm aufweist.

2. Elektrische Durchführung (1) gemäß Anspruch 1, **dadurch gekennzeichnet, dass** der Grundkörper (10) mit einer Oberflächenbeschichtung versehen ist, insbesondere einer Nickelschicht, insbesondere einer galvanisch aufgebrachten Nickelschicht.

3. Elektrische Durchführung (1) gemäß Anspruch 1 oder 2, **dadurch gekennzeichnet, dass** der Grundkörper (10) eine im Wesentlichen rechteckige Form aufweist, und ein Seitenverhältnis L/B einer Längsseite (24) der Länge L zu einer Querseite (22) der Breite B des Grundkörpers (10) im Bereich von 1,5 bis 10 liegt.

4. Elektrische Durchführung (1) gemäß Anspruch 3, **dadurch gekennzeichnet, dass** der Grundkörper (10) aus einem Metallmaterial besteht, dessen Faserverlauf (16) parallel zu der Längsseite (24) ausgerichtet ist.

5. Elektrische Durchführung (1) gemäß Anspruch 3 oder 4, **dadurch gekennzeichnet, dass** der Grundkörper (10) zumindest an den Rändern der Längsseite (24) eine Verstärkungsstruktur (40) aufweist, wobei die Verstärkungsstruktur (40) bevorzugt als erhöhter Randbereich ausgeführt ist, der gegenüber einer Grundebene (11) des Grundkörpers (10) vertikal versetzt ist.

6. Elektrische Durchführung (1) gemäß einem der Ansprüche 1 bis 5, **dadurch gekennzeichnet, dass** um die mindestens eine Öffnung (12) herum ein erhöhter oder vertiefter Verstärkungsbereich ausgebildet ist, wobei der erhöhte oder vertiefte Verstärkungsbereich vertikal gegenüber einer Grundebene (11) des Grundkörpers (10) versetzt ist und wobei eine Stärke des erhöhten oder vertieften Verstärkungsbereichs einer Dicke (D) des Grundkörpers (10) entspricht.

7. Elektrische Durchführung (1) gemäß einem der Ansprüche 1 bis 6, **dadurch gekennzeichnet, dass** die elektrische Durchführung (2) als Anschlussterminal für einen E-Kompressor ausgebildet ist.

8. Verfahren zur Herstellung einer elektrischen Durchführung (1) mit einem Grundkörper (10) gemäß einem der Ansprüche 1 bis 7, wobei das Verfahren umfasst
- Formen eines Grundkörpers (10) mit zumindest einer Öffnung (12) aus einem Rohling, wobei Kanten, welche die Öffnung (12) umgeben, scharf ausgebildet werden und die Kanten einer Außenkontur des Grundkörpers (10) mit einer Fase oder einer Verrundung (18) versehen werden, welche einen Radius r im Bereich von 0,3 mm bis 2 mm aufweist,
- Einsetzen eines Fixiermaterialrohlings und eines Leiters (30) in zumindest eine der Öffnungen (12), und
- Ausführung einer Temperaturbehandlung zum Ausbilden des Fixiermaterials (20) aus dem Fixiermaterialrohling.

9. Verfahren nach Anspruch 8, **dadurch gekennzeichnet, dass** das Erzeugen der Öffnungen (12) und das Einbringen der Fasen und/oder Rundungen (18) an den Kanten in einem gemeinsamen Arbeitsschritt ausgeführt wird.

10. Verfahren nach Anspruch 8 oder 9, **dadurch gekennzeichnet, dass** der Grundkörper (10) aus einem Drahtmaterial (2) geformt wird, wobei das Drahtmaterial (2) durch Walzen in eine Querschnittsform gebracht wurde, bei der die Abmessung einer langen Seite der Breite B einer Querseite (22) des Grundkörpers (10) und die Abmessung einer kurzen Seite der Dicke D des Grundkörpers (10) entspricht, wobei das Formen des Grundkörpers (10) ein Abtrennen eines Rohlings aus dem Drahtmaterial (2) umfasst, wobei eine Länge einer Längsseite (24) des Rohlings der Länge L der Längsseite (24) des Grundkörpers (10) entspricht, wobei das Drahtmaterial (2) bereits vor dem Abtrennen des Rohlings an seinen Kanten mit einer Verrundung (18) mit Radius r versehen ist, wobei diese Verrundung (18) nach dem Abtrennen eine Verrundung (18) entlang der Kanten an den Längsseiten (24) des Grundkörpers (10) bildet.

11. Verfahren nach einem der Ansprüche 8 bis 10, **dadurch gekennzeichnet, dass** der Grundkörper (10) vor dem Ausführen der Temperaturbehandlung unter Verwendung eines Trommelbeschichtungsverfahrens galvanisch mit Nickel beschichtet wird.
